Europäisches Patentamt

European Patent Office

Office européen des brevets

(11) Publication number: **0 009 992**

A1

## EUROPEAN PATENT APPLICATION

(21) Application number: **79302142.9**

(22) Date of filing: **09.10.79**

(51) Int. Cl.³: **H 05 K 1/16**
H 01 C 7/00, H 05 K 3/00
H 05 K 3/02, G 01 F 23/10

Priority: **10.10.78 GB 4004678**

(43) Date of publication of application:
**16.04.80 Bulletin 80/8**

(84) Designated Contracting States:
**DE FR GB**

(71) Applicant: **BAKELITE UK LIMITED**
**Redfern Road**
**Tyseley Birmingham, B11 2BJ(GB)**

(72) Inventor: **Rippington, George**
**Bakelite UK Limited Redfern Road**
**Tyseley Birmingham, B11 2BJ(GB)**

(74) Representative: **Ryan, Edward Terrence et al,**
**BP TRADING LIMITED Patents and Licensing Division**
**Chertsey Road**
**Sunbury-on-Thames Middlesex, TW16 7LN(GB)**

(54) **Articles from resistance foils and their use.**

(57) The resistance of an article (e.g. a printed resistor for a fuel gauge) to solvents e.g. petrol, comprising a layer of resistance foil bonded to an insulating substrate is improved by providing the surface of the foil is in contact with the insulating substrate with a layer of finely divided resistance metal particles bonded to the foil. Laminates for making printed resistors are disclosed.

EP 0 009 992 A1

TITLE MODIFIED
see front page

1

ARTICLES FROM METAL FOILS

The present invention relates to printed resistors for use in environments containing solvents and/or solvent vapours, and to insulating substrates carrying foils of resistance metal for preparing such printed resistors.

Wire-wound resistors made by winding a resistance wire onto a former are well known, and are used in control or measurement circuits of various types for example as rheostats. It is known to make resistors by the printed circuit technique in which a foil of resistance metal is bound to an electrical insulating material and a portion of the foil is etched away so as to leave a pattern of resistance material giving the desired resistance circuit. Resistors made in this way (printed resistors) may be used as a replacement for wire wound resistors, and are disclosed for example in British patent specification 951 660. The nature of the insulating substrate may be such that it is possible to cause the metal foil to adhere to it without the use of a separate adhesive layer. Adhesives for causing metal foils to adhere to insulating substrates such as laminates of fibrous reinforcement and thermosetting resin are well known.

Wire wound resistors are used as components in the production of fuel gauges for indicating the level of fuel in tanks, in particular the level of petrol or diesel fuel in the tanks of cars or other vehicles driven internal combustion engines. It would be desirable to replace wire wound resistors by resistors produced by the printed circuit technique mentioned above. However the resistors are located within the fuel tank and it is therefore essential for them to be resistant to the action of the liquid fuel. It is found that when printed resistors are prepared from foils of resistance metal which are fixed to the insulating substrate by a conventional adhesive the metal foil rapidly becomes detached from the underlying insulating substrate when immersed in petrol. The obvious solution to this problem is to use an adhesive which is stronger and more resistant to the action of petrol for example one based on a nitrile rubber. It is found however that even with such adhesives an undesirable reduction in peel strength takes place on immersion in petrol (gasoline). Peel strength is a measure of the ease with which the metal foil can be removed from the underlying insulating material. In the preparation of printed resistors for use in contact with solvents such as petrol it is extremely undesirable for any change in peel strength to take place on immersion in the solvent. Obtaining a material which has a high peel strength after immersion in petrol is of less importance than obtaining a material which has an adequate peel strength which remains unchanged after immersion in petrol. It does not appear possible to obtain such a material even when using adhesives believed to be resistant to petrol and some other solvents.

According to the present invention there is provided an article comprising a layer of resistance foil bonded to an insulating substrate characterised in that the surface of the resistance metal foil in contact with the insulating substrate carries a layer of finely divided resistance metal particles bonded to the foil.

The resistance metal used in the present invention may be any of the resistance metals known in the art for use in providing resistance circuits. Examples of such resistance metals are those sold under the Trade Names "Telconstan" "Ferry" "Isotan", which are alloys of copper and nickel, "Maganin", which is an alloy of copper, manganese and nickel, and "Nichrome" and "Inconel" which are alloys of nickel, iron and chromium. The preferred resistance metal is a copper/nickel alloy.

The insulating substrate may for example be a laminate prepared

by subjecting one or more layers of fibrous reinforcement and a thermosetting binder resin to the action of heat and pressure. Examples of suitable reinforcements are paper, woven glass fabric, non woven glass mat, glass felt and cotton or synthetic fibres.

Examples of suitable resins are epoxy, phenolic (all types), melamine-formaldehyde, urea formaldehyde, silicone and polyester.

It may be possible to cause the resistance metal foil to adhere to the insulating substrate by the action of the thermosetting resin used to bind the constituents of the insulating substrate together. Where the insulating material comprises a thermoset epoxy resin the metal foil may be bonded to the insulating substrate by applying the foil directly to the uncured or partially cured epoxy resin followed by curing of the resin to bind the metal foil. Where the binder resin is a phenolic resin it may be desirable to use an adhesive layer between the phenolic resin and the metal foil. Such adhesives are well known to those skilled in the art of bonding metal foils to phenolic resins. The adhesive is desirably one which is resistant to the action of petrol and similar solvents.

The foil of resistance metal carries on its under side a layer of finely divided resistance metal particles bonded to the foil. The presence of this finely divided layer is shown by a dark deposit on the normally light coloured, relatively shiny, foil surface.

Methods of producing finely divided metal particles adhering to the surface of the foil are well known to those skilled in the art. Thus British patent 1 413 494 (Yates Industries) discloses a method of building up an adherent metal layer on copper foil by electrochemical treatment. Similar procedures for treating copper foil are disclosed in British patent 1 349 696 (Yates). Methods of modifying these techniques to produce finely divided resistance metal particles adhering to the resistance metal foil will be apparent to those skilled in the art of treating metal foils.

The present invention embraces an insulating substrate covered by a sheet of resistance foil, such an article being suitable for the preparation of a printed resistor by a printed circuit technique. The invention also embraces a printed resistor wherein the resistance circuit has been formed by removal of a portion of the sheet of resistance foil. The invention further embraces a fuel gauge comprising a printed resistor in accordance with the invention across which a contact is moved by the action of a float responding to the level of fuel so as to produce a variation in resistance measured across the resistor in accordance with the position of the contact. Fuel gauges based on variations in resistances resulting from movements of a float are very well known in the art. An example of such a gauge is disclosed in Automobile Engineer's Reference Book published by Newnes 3rd Edition 24-22. An arm pivoted at a fixed point in the fuel tank carries a float which moves up and down in response to changes in the fuel level. The arm carries a wiper arm which moves over a resistor. One end of the resistor is connected to a suitable display device, while the wiper arm is connected to earth.

In view of the well known nature of these devices further description is not necessary.

The invention will now be illustrated by reference to the following Examples.

Example 1

0.001" thick (0.025 mm) rolled cupro-nickel foil (55% copper/ 45% nickel - known under the Trade Names "Telconstan", "Ferry", "Isotan") is chemically cleaned by immersion in a hot aqueous alkaline solution to remove rolling fluids, soils, etc. The foil is then treated electrochemically to deposit on one side very adherent finely divided particles of copper and nickel to increase the surface area for subsequent bonding.

The foil is then placed treated side down on top of a stack of 9 sheets of woven glass fabric impregnated with epoxy resin with the resin in the 'B' Stage and with a resin content approximately 40% by weight. A sheet of polymeric release sheet is placed on the bottom of the stack. The stack is then subjected to a pressure of 500 $lbf/in^2$ (34 bar) between stainless steel plates heated to 170°C, maintained at that temperature for 50 minutes and cooled to ambient temperature before removal of the pressure. The consolidated sheet is then removed from the stainless steel plates and the release film stripped off to provide a $^1$/16" (1.6 mm) thick resistance metal clad laminate.

(The glass fabric is 6 oz/sq. yd. (204 g/m$^2$), 42 x 32 threads per inch (per 25.4 mm) – Style 274 from Marglass Company Limited – treated with a silane coupling agent.

The fabric is impregnated with epoxy resin – DER 511 from Dow Chemical Company containing dicyandiamide as hardener and benzyl dimethylamine as catalyst.

The material is dried in an oven to remove solvent and to convert the resin to a 'B' state. The polymeric film is polyvinyl fluoride – Trade Name "Tedlar" from DuPont).

Example 2

(A Comparative Example, not according to the invention). As Example 1 except the cupro-nickel foil is chemically cleaned and is then coated on one side with an adhesive comprising a solution of an acrylonitrile butadiene rubber and a thermosettable phenol-formaldehyde resin (e.g. 200 TF from Shipley Chemicals Company Limited). The solvent is removed by passing the foil through an oven to provide a tack-free coating of 20-30 g/m$^2$. This foil is placed adhesive side down on top of the stack of impregnated glass fabric sheets.

Example 3

(A Comparative Example, not according to the invention). As Example 1 except the cupro-nickel foil is chemically cleaned only.

Example 4

As Example 1 except the foil is placed treated side down on to one sheet of epoxy resin impregnated glass fabric placed on top of one sheet of 18 s.w.g. (1.22 mm thick) aluminium sheet. (The aluminium sheet provides an earthed ground plane or a heat sink for applications where one or both may be required). (S.W.G. is standard wire gauge).

Example 5

The cupro-nickel foil is chemically cleaned and electrochemically treated as in Example 1 and is then adhesive coated as in Example 2 on the treated side. The foil is placed adhesive side down on top of a stack of 8 sheets of 150 g/m$^2$ electrical grade of kraft paper impregnated with phenol-formaldehyde resin to a resin content of approximately 45% and to a percentage of volatile matter removable in 5 min at 150°C of 3-5%. The stack is then subjected to a pressure of 1500 lbf/in$^2$ (102 bar) between stainless steel plates heated to 160°C. maintained at that temperature for 40 minutes and cooled to ambient temperature before removal of the pressure. The consolidated sheet is then removed from the stainless steel plates to provide a $^1$/16" (1.6 mm) thick resistance metal clad laminate.

Example 6

(A Comparative Example, not according to the invention). As Example 5 except the foil is chemically cleaned only and then adhesive coated and moulded as in Example 5.

The resistance metal clad laminates described in Examples 1 to 6 were printed and etched to provide a simple test pattern comprising a series of 2.0 mm wide tracks. Peel strengths (i.e. the force required to separate the foil from the base laminate) were carried out initially. Then the test patterns were immersed in the petroleum mixture described in DIN 51604 Pt 1. The solvent was continuously refluxed at 65°C for 168 hours (7 days). The peel strengths were then re-measured and expressed as percentage of the initial values.

The following Table provides the results obtained:

|  | Initial peel strength (g) | Peel strength after solvent immersion (g) | % strength retention |
|---|---|---|---|
| Example 1 | 150 | 150 | 100 |
| 2 | 300 | 0 | 0 |
| 3 | 20 | 0 | 0 |
| 4 | 150 | 150 | 100 |
| 5 | 400 | 400 | 100 |
| 6 | 300 | 0 | 0 |

Examples 1, 4 and 5, which are made in accordance with the invention, are considered to have satisfactory resistance to petrol.

Example 3 is unsatisfactory on initial peel strength.

Examples 2 and 6 are considered to have unsatisfactory resistance to petrol although their initial peel strength values are very satisfactory.

Claims:

1. An article which comprises a layer of resistance foil bonded to an insulating substrate characterised in that the surface of the resistance metal foil in contact with the insulating substrate carries a layer of finely divided resistance metal particles bonded to the foil.

2. An article according to claim 1 wherein the resistance metal is a copper/nickel alloy.

3. An article according to claims 1 or 2 wherein the insulating substrate is a laminate formed by subjecting one or more layers of fibrous reinforcement and a thermosetting binder resin to the action of heat and pressure.

4. An article according to any one of the preceding claims wherein there is a layer of adhesive between the resistance metal and the insulating substrate.

5. An article according to any one of the preceding claims which is a printed resistor formed by removal of part of a sheet of resistance metal bonded to the insulating substrate.

6. A fuel gauge which comprises a resistor across which an arm is caused to move by the action of a float responding to the level of fuel so as to produce a variation in resistance measured across the resistor, characterised in that the resistor consists of a layer of resistance foil bonded to an insulating substrate, and the surface of the foil bonded to the substrate carries a layer of finely divided resistance metal particles bonded to the foil.

0009992

Application number

EP 79 30 2142

# European Patent Office

# EUROPEAN SEARCH REPORT

## DOCUMENTS CONSIDERED TO BE RELEVANT

| Category | Citation of document with indication, where appropriate, of relevant passages | Relevant to claim |
|---|---|---|
| X | FR - A - 1 366 903 (ASSOCIATION DES OUVRIERS EN INSTRUMENTS DE PRECISION)<br><br>* Page 1, column 1, paragraph 2 to page 3, column 1, paragraph 3; abstract *<br><br>& US - A - 3 389 061<br><br>-- | 1-4 |
| X | FR - A - 2 147 241 (INTERNATIONAL STANDARD ELECTRIC CORP.)<br><br>* Page 1, line 1 - page 3, line 5; claims *<br><br>-- | 1,2 |
|  | GB - A - 1 159 806 (SMITHS INDUSTRIES LTD.)<br><br>* Page 2, line 17 to page 3, line 104; figures 4-6 *<br><br>-- | 6 |
|  | GB - A - 835 215 (PAUL EISLER U.K.)<br><br>* Page 3, line 51 to page 4, line 123; figures 1-3 *<br><br>-- | 1,5 |
|  | US - E - 28 597 (TDK ELECTRONICS CO. LTD.)<br><br>* Column 2, line 49 to column 4, line 15; claims *<br><br>-- | 5 |
|  | US - A - 3 728 178 (OLIN CORP.)<br><br>* Claims *<br><br>---- | 1 |

### CLASSIFICATION OF THE APPLICATION (Int. Cl. ³)

H 05 K   1/16
H 01 C   7/00
H 05 K   3/00
         3/02
G 01 F  23/10

### TECHNICAL FIELDS SEARCHED (Int.Cl. ³)

H 05 K   1/16
H 01 C   7/00
         7/22
H 05 K   3/00
         3/02
G 01 F  23/10

### CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 17-01-1980 | GORUN |

EPO Form 1503.1   06.78